# EUROPEAN PATENT APPLICATION

(11) **EP 2 117 286 A1**
(43) Date of publication of application: **11.11.2009**
(21) Application number: 09251262.3
(22) Date of filing: 06.05.2009
(51) Int. Cl.: H05K 3/10, H05K 3/18

(54) **Method of manufacturing printed circuit board**

(30) Priority: 08.05.2008 JP 2008122363
(71) Applicant: Nitto Denko Corporation, Ibaraki-shi, Osaka 567-8680 (JP)
(72) Inventor: Morita- Shigenori, Ibaraki-shi, Osaka 567-8680 (JP); Oda, Takashi, Ibaraki-shi, Osaka 567-8680 (JP); Yoshida, Naoko, Ibaraki-shi, Osaka 567-8680 (JP)
(74) Representative: Gill, Stephen Charles

(57) **Abstract**

First, a catalyst for performing electroless plating in a subsequent step is caused to adhere to surfaces of uneven portions of a matrix. Next, an insulating layer made of a resin material is prepared. Then, the insulating layer is heated to be softened while the uneven portions of the matrix are pressed against one surface of the insulating layer. Thus, grooves corresponding to shapes of the uneven portions of the matrix are formed in the insulating layer while the catalyst is transferred to bottom surfaces and side surfaces of the grooves. The insulating layer is then subjected to electroless plating. In this case, metal is deposited by reduction reaction on portions of the insulating layer where the catalyst exists. Accordingly, conductor traces are formed in the grooves of the insulating layer.

## Description

### BACKGROUND OF THE INVENTION

### Field of the Invention

The present invention relates to a method of manufacturing a printed circuit board.

### Description of the Background Art

In recent years, finer conductor traces of printed circuit boards have been demanded as reduction in size and weight and more variety of functions have been achieved in electronic appliances. Methods of forming the conductor traces include a semi-additive method, for example (see JP 2006-156882 A, for example).

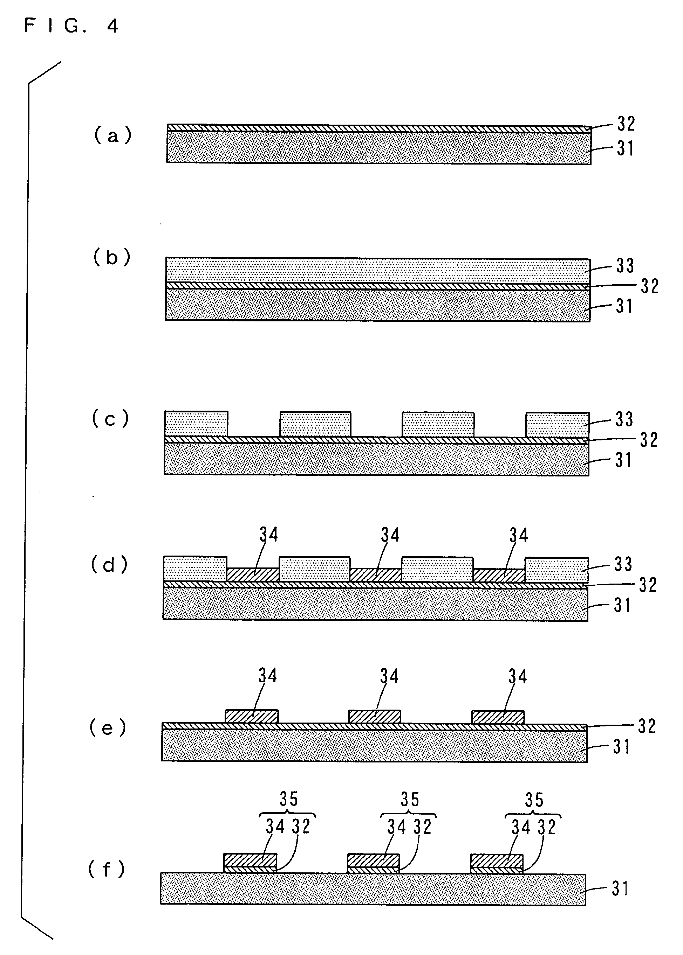

Fig. 4 is a schematic sectional view showing steps in one example of the method of manufacturing a printed circuit board using the semi-additive method.

As shown in Fig. 4 (a), first, a thin conductive film 32 is formed on an insulating layer 31. Next, a photo resist 33 is formed on the thin conductive film 32 as shown in Fig. 4 (b). Then, the photo resist 33 is exposed in a predetermined pattern, followed by development as shown in Fig. 4(c). Thus, the photo resist 33 is formed in the pattern opposite to that of conductor traces to be formed in a subsequent process.

Next, a conductor layer 34 made of copper, for example, is formed by electrolytic plating on exposed portions of the thin conductive film 32, as shown in Fig. 4 (d). The photo resist 33 is subsequently removed by etching or stripping as shown in Fig. 4 (e). Finally, exposed portions of the thin conductive film 32 are removed by etching as shown in Fig. 4 (f). In this manner, the conductor traces 35 composed of the thin conductive films 32 and the conductor layers 34 are formed.

When the foregoing semi-additive method is used, the fine conductor traces 35 can be precisely formed; however, the complicated manufacturing processes increase production cost.

### SUMMARY OF THE INVENTION

An object of the present invention is to provide a method of manufacturing a printed circuit board in which fine conductor traces can be formed at low cost.
(1) According to an aspect of the present invention, a method of manufacturing a printed circuit board having a wiring trace includes the steps of preparing a matrix having a projection whose shape corresponds to the wiring trace, causing a catalyst for plating to adhere to the projection of the matrix, forming a recess in an insulating layer by pressing the projection of the matrix against the insulating layer and transferring the catalyst adhering to the projection of the matrix to the recess formed in the insulating layer, and depositing metal by plating in the recess formed in the insulating layer.
   In the method of manufacturing the printed circuit board, the projection of the matrix is pressed against the insulating layer, so that the recess is formed in the insulating layer while the catalyst adhering to the projection of the matrix is transferred to the recess of the insulating layer. Then, the metal is deposited by plating in the recess of the insulating layer to which the catalyst has been transferred, thus forming the wiring trace.
   In this case, the fine wiring trace can be easily formed with the small number of steps. This reduces production cost of the printed circuit board.
(2) The plating may be electroless plating. In this case, the metal can be easily and reliably deposited in the recess of the insulating layer to which the catalyst has been transferred. This allows the fine wiring trace to be reliably formed at low cost.
(3) The method of manufacturing the printed circuit board may further include the step of forming the insulating layer on a base material, wherein the projection of the matrix may be pressed against the insulating layer formed on the base material.
   In this case, a material firmer than the insulating layer is used as a material for the base material, so that the printed circuit board can be made firmer.
(4) A thickness of the projection of the matrix may be larger than a thickness of the insulating layer, and the projection of the matrix may be pressed against the insulating layer formed on the base material such that the projection of the matrix penetrates the insulating layer to come into contact with the base material.
   In this case, the projection of the matrix has the larger thickness than that of the insulating layer. Therefore, when the projection of the matrix is pressed against the insulating layer such that the projection of the matrix penetrates the insulating layer to come in contact with the base material, the matrix other than its projection does not come into contact with the insulating layer. Thus, the catalyst can be accurately transferred only to the recess of the insulating layer even though the catalyst is adhering to the matrix other than the projection. This allows the fine wiring trace to be reliably formed.
(5) The catalyst may include precious metal. In this case, the metal can be reliably deposited in the recess of the insulating layer to which the catalyst has been transferred. This allows the fine wiring trace to be reliably formed.
(6) The catalyst may include at least one of palladium, platinum and gold. In this case, the metal can be more reliably deposited in the recess of the insulating layer to which the catalyst has been transferred. This allows the fine wiring trace to be more reliably formed.
(7) The catalyst may be caused to adhere to the projection of the matrix by vacuum evaporation. In this case, the catalyst can be caused to uniformly adhere to the projection of the matrix.
(8) The catalyst may be caused to adhere to the projection of the matrix by application. In this case, the catalyst can be caused to easily adhere to the projection of the matrix.

According to the present invention, the fine wiring trace can be easily formed with the small number of steps. This reduces the production cost of the printed circuit board.

Other features, elements, characteristics, and advantages of the present invention will become more apparent from the following description of preferred embodiments of the present invention with reference to the attached drawings.

### BRIEF DESCRIPTION OF THE DRAWINGS

Fig. 1 is a schematic sectional view for explaining steps in a method of producing a matrix used in manufacture of a printed circuit board.
Fig. 2 is a schematic sectional view for explaining steps in a method of forming conductor traces of the printed circuit board.
Fig. 3 is a schematic sectional view for explaining steps in a method of manufacturing a printed circuit board according to another embodiment.
Fig. 4 is a schematic sectional view showing steps in one example of the method of manufacturing the printed circuit board using a semi-additive method.

### DESCRIPTION OF THE PREFERRED EMBODIMENTS

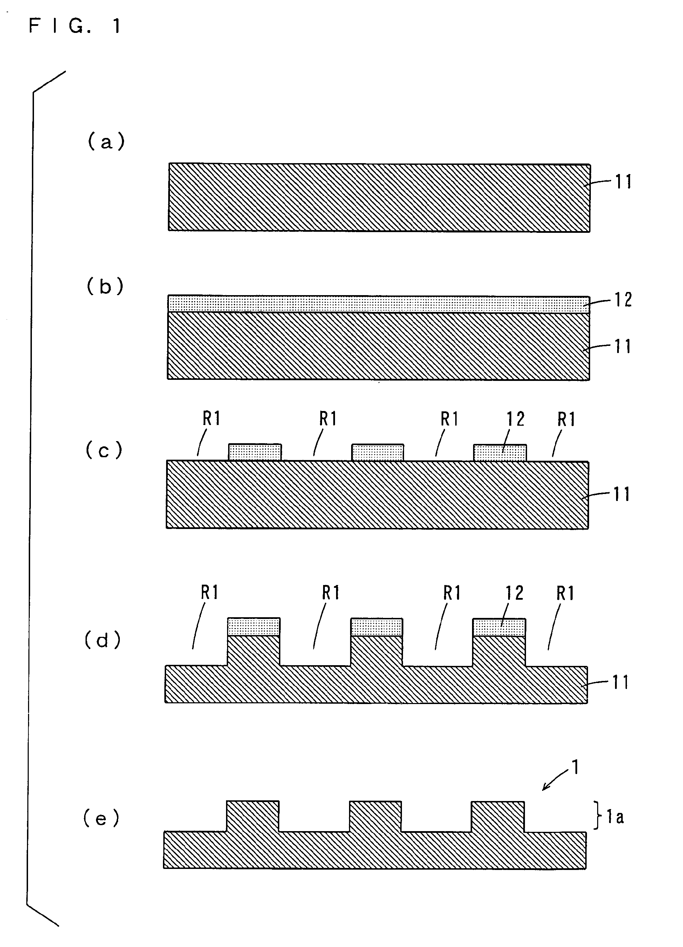

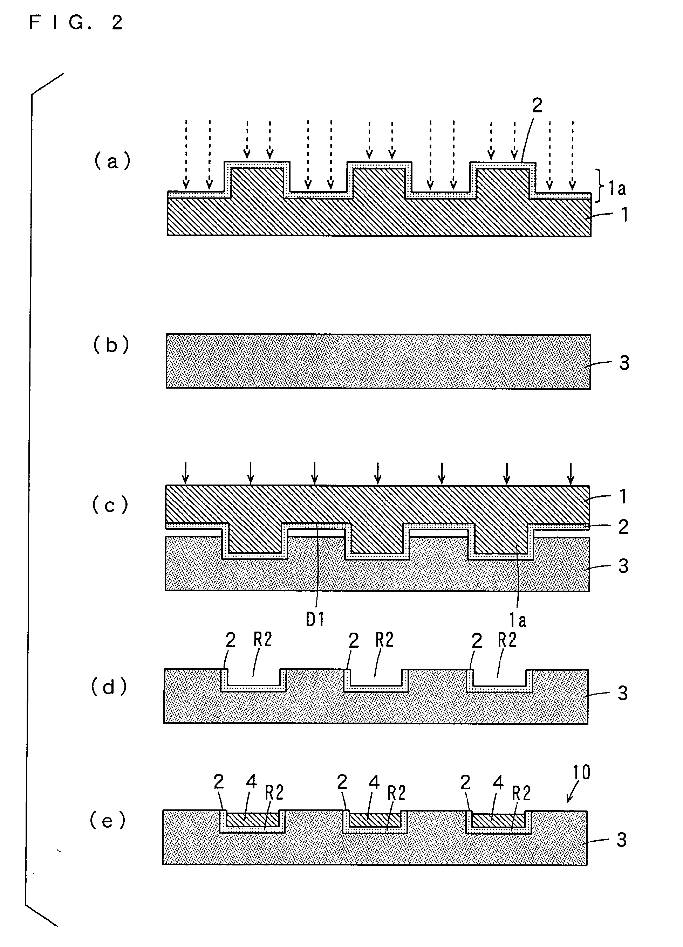

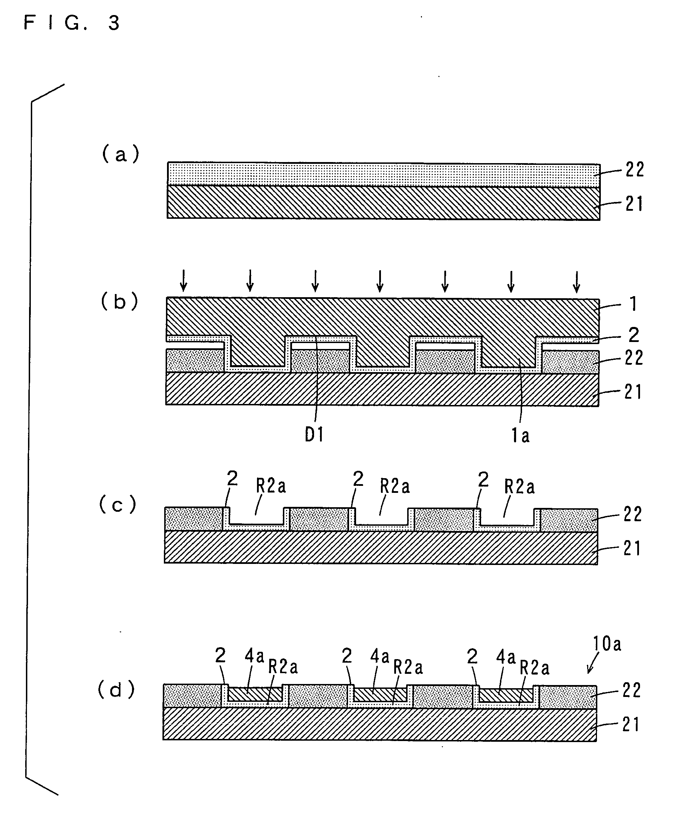

Hereinafter, a method of manufacturing a printed circuit board according to one embodiment of the present invention will be described while referring to the drawings.
(1) Method of Producing Matrix Fig. 1 is a schematic sectional view for explaining steps in a method of producing a matrix used in manufacture of the printed circuit board.
   As shown in Fig. 1 (a), first, a substrate 11 made of silicon, for example, is prepared. Then, as shown in Fig. 1 (b), a photo resist layer 12 is formed on the substrate 11 by spin coating, for example. Next, as shown in Fig. 1 (c), the photo resist layer 12 is exposed in a predetermined pattern, followed by development. This causes grooves (openings) R1 to be formed in a predetermined pattern in the photo resist layer 12.
   Portions of the substrate 11 inside the grooves R1 are subsequently removed to a predetermined depth by dry etching or wet etching as shown in Fig. 1 (d). Then, the photo resist layer 12 is removed as shown in Fig. 1 (e). This causes the matrix 1 having uneven portions 1a in a predetermined pattern to be completed. In the present embodiment, conductor traces of the printed circuit board are formed using the matrix 1.
   Note that another material such as Nickel (Ni) may be used as a material for the substrate 11. Moreover, a matrix made of nickel may be produced by a nickel electroforming technique using the produced matrix 1.
(2) Method of Forming the Conductor Traces
   Fig. 2 is a schematic sectional view for explaining steps in a method of forming the conductor traces of the printed circuit board.
   First, a catalyst 2 for performing electroless plating in a subsequent step is caused to adhere to surfaces of the uneven portions 1 a of the foregoing matrix 1, as shown in Fig.2 (a). Specifically, the catalyst 2 is evaporated on the surfaces of the uneven portions 1a of the matrix 1 by vacuum evaporation. The catalyst 2 may be applied to the surfaces of the uneven portions 1a of the matrix 1 using a method such as immersing the uneven portions 1a of the matrix 1 in a solution containing the catalyst 2, spraying the solution containing the catalyst 2 to the uneven portions 1a of the matrix 1 or the like and subsequently dried to adhere thereto. Precious metal such as platinum, gold, palladium or silver can be used as the catalyst 2.
   An insulating layer 3 made of a resin material is then prepared as shown in Fig. 2 (b). Polyimide, polyethylene terephthalate, PMMA (polymethylmethacrylate) resin, polycarbonate, polylactic acid, epoxy resin or the like can be used as a material for the insulating layer 3. Particularly, a material having a low glass transition temperature such as low-molecular-weight PMMA is preferably used as the material for the insulating layer 3.
   Then, the insulating layer 3 is heated to be softened, and the uneven portions 1a of the matrix 1 are pressed against one surface of the insulating layer 3 as shown in Fig. 2 (c). In this case, clearances are formed between bottom surfaces D1 of the uneven portions 1a of the matrix 1 and the surface of the insulating layer 3 such that the catalyst 2 adhering to the bottom surfaces D1 of the uneven portions 1a of the matrix 1 does not come into contact with the surface of the insulating layer 3.
   In this manner, grooves R2 corresponding to shapes of the uneven portions 1a of the matrix 1 are formed in the insulating layer 3 while the catalyst 2 is transferred to bottom surfaces and side surfaces of the grooves R2 as shown in Fig. 2 (d). Note that the surfaces of the uneven portions 1a of the matrix 1 may be previously subjected to mold release processing in order to reliably transfer the catalyst 2 from the matrix 1 to the insulating layer 3.
   Note that a too low heating temperature of the insulating layer 3 does not sufficiently soften the insulating layer 3, thus failing to well form the grooves R2. Meanwhile, a too high heating temperature is liable to break the insulating layer 3. The heating temperature of the insulating layer 3 is preferably not less than 60 °C and not more than 350 °C in order to well form the grooves R2 in the insulating layer 3.
   Formation of the grooves R2 using the matrix 1 may be performed under a reduced-pressure atmosphere or an atmospheric pressure. The formation may be performed in the air or in an inert gas.
   The grooves R2 cannot be formed when the matrix 1 is pressed against the insulating layer 3 with a too small pressure. Meanwhile, when the matrix 1 is pressed against the insulating layer 3 with a too large pressure, the catalyst 2 adhering to the bottom surfaces D1 of the uneven portions 1a are liable to be transferred to the surface of the insulating layer 3. In addition, the insulating layer 3 may be broken or the matrix 1 may be damaged. The matrix 1 is preferably pressed against the insulating layer 3 with a pressure of not less than 0.1 MPa and not more than 1000 MPa.
   Next, the electroless plating is performed to the insulating layer 3. Silver, copper, nickel or the like is used as a plating solution of the electroless plating. In this case, metal is deposited by reduction reaction on portions of the insulating layer 3 where the catalyst 2 exists. Accordingly, the conductor traces 4 are formed in the grooves R2 of the insulating layer 3 as shown in Fig. 2 (e). In this manner, the conductor traces 4 of the printed circuit board are formed.
   Note that the electroless plating is superior in thickness control. Thus, the thickness of the conductor traces 4 can be adjusted to be equal to the depth of the grooves R2 to cause the surface of the insulating layer 3 to be flat. In addition, the conductor traces 4 formed by the electroless plating are further subjected to electrolytic plating as a feed layer, thereby allowing the thickness of the conductor traces 4 to be further increased.
(3) Effects
   In the present embodiment, the catalyst 2 for the electroless plating is transferred to the insulating layer 3 using the matrix 1, so that the fine conductor traces 4 can be easily formed with the small number of steps. This reduces production cost of the printed circuit board.
(4) Other Embodiments
   Fig. 3 is a schematic sectional view for explaining steps in a method of manufacturing a printed circuit board according to another embodiment. The method of manufacturing the printed circuit board shown in Fig. 3 is described by referring to differences from the foregoing manufacturing method.
   As shown in Fig. 3 (a), an insulating layer 22 made of a resin material is formed on a base material 21 made of an insulating film, for example. The thickness of the insulating layer 22 is set smaller than the depth of recesses of the uneven portions 1a of the matrix 1. Note that polyimide or the like, for example, can be used as a material for the base material 21, and epoxy resin or the like, for example, can be used as a material for the insulating layer 22.
   Next, the insulating layer 22 is heated to be softened, and the uneven portions 1a of the matrix 1 (see Fig. 1) are pressed against one surface of the insulating layer 22 as shown in Fig. 3(b). Then, the uneven portions 1a are brought into contact with a surface of the base material 21. In this case, the thickness of the insulating layer 22 is smaller than the depth of the recesses of the uneven portions 1a, and therefore clearances are formed between the surface of the insulating layer 22 and the bottom surfaces D1 of the uneven portions 1a of the matrix 1.
   Accordingly, holes R2a corresponding to the shapes of the uneven portions 1a of the matrix 1 are formed in the insulating layer 22 while the catalyst 2 is transferred to side surfaces of the holes R2a and the surface of the base material 21 inside the holes R2a as shown in Fig. 3 (c).
   Then, conductor traces 4a are formed by the electroless plating in regions of the insulating layer 22 inside the holes R2a where the catalyst 2 exists as shown in Fig. 3 (d).
   Note that when a resin material is used as the base material 21, a comparatively firm resin material such as polyimide is preferably used to keep strength. For the insulating layer 22, a comparatively soft resin material suitable for molding epoxy resin or the like is preferably used.
   A metal plate made of copper, SUS (Stainless Steel), aluminum, nickel or the like, or a metal foil made of copper, SUS or the like may be used as the base material 21. In this case, the uneven portions 1a are not brought into contact with the surface of the base material 21 when the uneven portions 1a of the matrix 1 are pressed against the insulating layer 22. This causes the insulating layer 22 to be sandwiched between the conductor traces 4a and the base material 21, preventing electrical connection between the conductor traces 4a and the base material 21.
(5) Inventive Examples
   The conductor traces 4, 4a were formed in various conditions, and their states were examined.
(5-1) Inventive Example 1
   A PET (polyethylene terephthalate) film having the thickness of 100 µm as the insulating layer 3 and the matrix 1 made of silicon were employed. The uneven portions 1a whose pattern has the L/S (line width and spacing) of 1 µm are provided in the matrix 1, and platinum and palladium were evaporated on the surfaces of the uneven portions 1a as the catalyst 2 by ion sputtering.
   Under the reduced-pressure atmosphere, the insulating layer 3 was heated to 170 °C, and the matrix 1 was pressed against the insulating layer 3 for 180 seconds at a pressure of 20 MPa. Then, the electroless plating was performed for 10 minutes at 40 °C using a copper plating liquid.
   As a result, the conductor traces 4 having the thickness of 0.5 µm were well formed in the grooves R2 having the L/S of 1 µm formed in the insulating layer 3.
(5-2) Inventive Example 2
   A copper foil was used as the base material 21, and PMMA (polymethylmethacrylate) having a molecular weight of 15000 dissolved in toluene was applied onto the base material 21 by spin coating. In this manner, the insulating layer 22 having the thickness of 10 µm was formed. The matrix 1 made of silicon was used. The uneven portions 1a whose pattern has the L/S of 5 µm, 10 µm and 50 µm were provided in the matrix 1, and platinum and palladium were evaporated on the surfaces of the uneven portions 1a as the catalyst 2 by ion sputtering.
   Under the reduced-pressure atmosphere, the insulating layer 22 was heated to 120 °C, and the matrix 1 was pressed against the insulating layer 22 for 180 seconds at a pressure of 20 MPa. Then, the electroless plating was performed for 60 minutes at 40 °C using a copper plating liquid.
   As a result, the conductor traces 4 having the thickness of 1 µm were well formed in the grooves R2a having the L/S of 5 µm, 10 µm and 50 µm formed in the insulating layer 22.
(5-3) Inventive Example 3
   The conductor traces were formed in the same condition as in the inventive example 2 except that gold was used as the catalyst 2.
   As a result, the conductor traces 4a having the thickness of 1 µm were well formed in the grooves R2a having the L/S of 5 µm, 10 µm and 50 µm formed in the insulating layer 22.
(5-4) Inventive Example 4
   The conductor traces were formed in the same condition as in the inventive example 3 except that a time period where the matrix 1 was pressed against the insulating layer 22 was 60 seconds.
   As a result, the conductor traces 4a having the thickness of 1 µm were well formed in the grooves R2a having the L/S of 5 µm, 10 µm and 50 µm formed in the insulating layer 22.
(5-5) Inventive Example 5
   The conductor traces were formed in the same condition as in the inventive example 3 except that a heating temperature of the insulating layer 2 when the matrix 1 was pressed against the insulating layer 3 was 80 °C.
   As a result, the conductor traces 4a having the thickness of 1 µm were well formed in the grooves R2a having the L/S of 5 µm, 10 µm and 50 µm formed in the insulating layer 22.
(5-6) Inventive Example 6
   The conductor traces were formed in the same condition as in the inventive example 3 except that the uneven portions 1a whose pattern has the L/S of 1 µm were provided in the matrix 1, and a time period where the electroless plating was performed was 30 minutes.
   As a result, the conductor traces 4a having the thickness of 1 µm were well formed in the grooves R2a having the L/S of 1 µm formed in the insulating layer 22.
(5-7) Inventive Example 7
The conductor traces were formed in the same condition as in the inventive example 2 except that the time period where the electroless plating was performed was 120 minutes.
   As a result, the conductor traces 4a having the thickness of 5 µm were well formed in the grooves R2a having the L/S of 5 µm, 10 µm and 50 µm formed in the insulating layer 22.
(6) Correspondences between Elements in the Claims and Parts in Embodiments
   In the following paragraph, non-limiting examples of correspondences between various elements recited in the claims below and those described above with respect to various preferred embodiments of the present invention are explained.

In the foregoing embodiments, the conductor traces 4, 4a are examples of a wiring trace, projections of the uneven portions 1a of the matrix 1 are examples of a projection of a matrix, the grooves R2 and the holes R2a of the insulating layers 3, 22 are examples of a recess of an insulating layer.

As each of various elements recited in the claims, various other elements having configurations or functions described in the claims can be also used.

While preferred embodiments of the present invention have been described above, it is to be understood that variations and modifications will be apparent to those skilled in the art.

## Claims

1. A method of manufacturing a printed circuit board having a wiring trace, comprising the steps of:
preparing a matrix having a projection whose shape corresponds to said wiring trace;
causing a catalyst for plating to adhere to the projection of said matrix;
forming a recess in an insulating layer by pressing the projection of said matrix against said insulating layer and transferring the catalyst adhering to the projection of said matrix to the recess formed in said insulating layer; and
depositing metal by plating in the recess formed in said insulating layer.

2. The method of manufacturing the printed circuit board according to claim 1, wherein said plating is electroless plating.

3. The method of manufacturing the printed circuit board according to claim 1 or 2, further comprising the step of forming said insulating layer on a base material, wherein
the projection of said matrix is pressed against said insulating layer formed on said base material.

4. The method of manufacturing the printed circuit board according to claim 3, wherein
a thickness of the projection of said matrix is larger than a thickness of said insulating layer, and
the projection of said matrix is pressed against said insulating layer formed on said base material such that the projection of said matrix penetrates the insulating layer to come into contact with said base material.

5. The method of manufacturing the printed circuit board according to any one of the previous claims, wherein said catalyst includes precious metal.

6. The method of manufacturing the printed circuit board according to claim 5, wherein said catalyst includes at least one of palladium, platinum and gold.

7. The method of manufacturing the printed circuit board according to claim 5 or 6, wherein the catalyst is caused to adhere to the projection of said matrix by vacuum evaporation.

8. The method of manufacturing the printed circuit board according to claim 5 or 6, wherein the catalyst is caused to adhere to the projection of said matrix by application.
